# EUROPÄISCHE PATENTSCHRIFT

(11) **EP 2 078 313 B1**
(45) Veröffentlichungstag und Bekanntmachung des Hinweises auf die Patenterteilung: **18.12.2019**
(21) Anmeldenummer: 07817614.6
(22) Anmeldetag: 01.10.2007
(51) Int. Cl.: H01L 51/42

(54) **Photovoltaische Anordnungen mit Fasern als Trägerschichten**
Photovoltaic devices with fibers as carrier layers
Dispositifs photovoltaïques avec des couches de support comprenant des fibres

(30) Priorität: 02.10.2006 DE 102006047045
(43) Veröffentlichungstag der Anmeldung: 15.07.2009
(73) Patentinhaber: Universität Paderborn, 33098 Paderborn (DE)
(72) Erfinder: GREULICH-WEBER, Siegmund, 33175 Bad Lippspringe (DE); FRIEDEL, Bettina, 33100 Paderborn (DE); ZÖLLER, Marc, 33106 Paderborn (DE)
(74) Vertreter: Schneider, Uwe
(86) Internationale Anmeldenummer: PCT/DE2007/001772
(87) Internationale Veröffentlichungsnummer: WO 2008/040333

(56) Entgegenhaltungen:
- EP-A- 1 369 923
- WO-A2-2006/138671
- FR-A- 2 856 197
- JP-A- 6 283 733
- US-A1- 2005 257 827
- US-B2- 7 063 994
- G. W. MENG, L. D. ZHANG, C. M. MO, S. Y. ZHANG, Y. QIN, S. P. FENG, H. J. LI: "Synthesis of "A beta-SiC nanorod within a SiO2 nanorod" one dimensional composite nanostructures" SOLID STATE COMMUNICATIONS, Bd. 106, Nr. 4, 4. April 1998 (1998-04-04), Seiten 215-219, XP002492009 Great Britain
- BAPS B ET AL: "Ceramic based solar cells in fiber form", KEY ENGINEERING MATER, TRANS TECH PUBLICATIONS LTD., STAFA-ZURICH, CH, vol. 206-213, no. PART 2, 9 September 2001 (2001-09-09), pages 937-940, XP008022335, ISSN: 1013-9826

## Beschreibung

Die Erfindung betrifft photovoltaische Einrichtungen gemäß Oberbegriff der Ansprüche 1 oder 2 sowie ein Verfahren zur Herstellung von Fasern für Trägerschichten zur Bildung einer photovoltaischen Einrichtung gemäß Anspruch 11 und ein Verfahren zur Herstellung eines Schichtaufbaus für eine photovoltaische Einrichtung gemäß Anspruch 16.

Bei der Gewinnung von Solarenergie mittels photovoltaischer Elemente basiert die heute einsetzbare Technik in der Regel auf der Verwendung von photovoltaischen Elementen auf der Basis von Silizium, die in Form von starren Paneelen Anwendung finden. Hierbei werden üblicherweise aus einer Anzahl von mittels konventioneller Verfahren der Siliziumtechnik hergestellten Einzelzellen aus Einkristallen derartige Paneele aufgebaut und miteinander verschaltet, so dass sich die in jeder einzelnen Zelle gebildeten Ladungen addieren. Problematisch hieran ist es, dass die einzelnen photovoltaischen Elemente eines derartigen Paneels aufgrund der Eigenschaften des Siliziums starr sind und sich daher nur aufwendig an bauseits vorhandene Gegebenheiten anpassen lassen.

Eine Möglichkeit zur Umgehung der Nachteile von Silizium auch aufgrund seiner mechanischen Eigenschaften kann in der Verwendung organischer oder Polymersolarzellen gesehen werden. Photovoltaische Effekte an organischen photoleitenden Materialien sind schon seit ein paar Jahrzehnten bekannt, konnten sich aber trotz der geringeren Herstellungskosten bis in die heutige Zeit kaum gegen die klassischen Silizium-Solarzellen durchsetzen. Seit ein paar Jahren werden photoaktive Polymere aber zunehmend zur Herstellung Form-flexibler Solarzellen genutzt. Das Funktionsprinzip der Polymer-Solarzellen beruht auf der Bildung von Exzitonen (Elektron-Loch-Paaren) in so genannten konjugierten Polymeren (Kunststoffe aus den Gruppen der Polyphenylene, Polyvinylphenylene, Polythiophene oder Polyaniline), durch Absorption von Licht. Durch die starke Bindung des Elektrons an das Polymer, hat das Exziton eine relativ kleine Diffusionslänge (Abstand des Elektrons zum auf der Polymer-Kette verbliebenen Loch) von etwa 100nm und rekombiniert relativ schnell. Da aber für photovoltaische Anwendungen eine möglichst lange Lebensdauer des photoinduzierten Zustands von Vorteil ist, benötigt man ein Akzeptormaterial, welches im Diffusionsbereich des Exzitons diese Elektronen abfangen und so am Rekombinieren hindern soll. In bekannten Realisierungen wird dies durch ein Komposit-Material aus konjugierten Polymeren und Fulleren-Derivaten erreicht, wie z.B. P3HT:PCBM oder MDMO-PPV:PCBM, dabei findet ein Transfer des Elektrons vom Polymer auf das Fulleren statt, das Loch verbleibt auf der Polymerkette. Eine übliche Polymer-Solarzelle ist aus mehreren Schichten aufgebaut, einem transparenten Trägermaterial, einer transparenten Kathode (meist ITO), der photoaktiven Komposit-Schicht, meist einer zusätzlichen p-leitenden Schicht (um die Löcher von der Polymerkette abzuleiten) und einer reflektierenden Anode (meist Aluminium). Durch den komplizierten Aufbau derartiger Polymersolarzellen geht ein Teil der materialseitig möglichen Vorteile und Eigenschaften wieder verloren, insbesondere sind die mechanische Flexibilität und Festigkeit und der Wirkungsgrad nicht befriedigend.

Aus der EP 1 369 923 A und der US 7 063 994 B2 sind Solarzellen herkömmlichen Aufbaus bekannt, die als Beschichtungsmaterialien für die Elektroden die üblichen Metalle und Stoffe der organischen Halbleitertechnik (Gold, Platin, Mg, Ca, Li, AI und eine Mg:Ag-Legierung oder organische leitende Materialien wie ITO) verwenden. Als Material für die eigentlichen Fasern wird nichtleitende Plastikfolie oder Glasfasern verwendet oder die Fasern aus selbstleitenden Metallen hergestellt. in bdeiden Schriften werden die Fasern selbst nicht aus Halbleitermaterialien hergestellt.

Die US 7 063 994 B2 zeigt einen Herstellungsprozess für SiC-Nano-Rods, die sich in einer SiO₂-Nano- oder Mikroröhre befinden. Man könnte auch von einem SiC-Nanodraht sprechen, der eine äußere SiO₂-Schicht besitzt, also SiC mit einer dicken Oxyd-Schicht. Die Herstellung geht zwar auch über einen Sol-Gel-Prozess, aber im Wesentlichen zur Herstellung der SiO₂-Nanostruktur, in der dann anschließend SiC-Nanorods wachsen.

Aufgabe der vorliegenden Erfindung ist es daher, eine gattungsgemäße Polymersolarzelle derart weiter zu entwickeln, dass sie eine erhöhte mechanische Flexibilität aufweist bei gleichbleibender oder erhöhter mechanischer Belastbarkeit.

Die Lösung der erfindungsgemäßen Aufgabe ergibt sich aus den kennzeichnenden Merkmalen der Ansprüche 1 oder 2 in Zusammenwirken mit den Merkmalen des jeweiligen Oberbegriffes. Weitere vorteilhafte Ausgestaltungen der Erfindung ergeben sich aus den Unteransprüchen.

Die Erfindung gemäß Anspruch 1 geht aus von einer photovoltaischen Einrichtung, aufweisend ein photovoltaisches Akzeptormaterial und ein photovoltaisches Donatormaterial. Eine derartige photovoltaische Einrichtung wird dadurch in erfindungsgemäßer Weise weiter entwickelt, dass die photovoltaische Einrichtung mindestens zwei Trägerschichten aufweist, von denen eine Trägerschicht n-dotierte Elektronendonatoren und die andere Trägerschicht Akzeptormaterial als p-dotierte oder undotierte Elektronenakzeptoren aufweist, wobei die Trägerschichten einander zumindest abschnittsweise berührend zueinander angeordnet sind und die Trägerschichten mit einem photovoltaischen Donatormaterial filmartig benetzt oder beschichtet sind. Man erhält auf diese Weise eine photovoltaische Einrichtung, die ähnlich wie eine Polymer-Solarzelle arbeitet, aber durch die im weiteren genannten möglichen Ausgestaltungen besondere Vorteile aufweist. Die Grundidee besteht darin, einen zweischichtigen Aufbau der photovoltaischen Einrichtung aus unterschiedlich dotierten Trägerschichten herzustellen (n- bzw. p-leitend) und diese mit photoaktiven Polymeren (z.B. P3HT, MDMO-PPV, MEH-PPV oder PFB) zu tränken oder zu benetzen. Einen wie vorstehend genannten Schichtaufbau mit einem konjugierten Polymer zu benetzen bringt als Vorteil, dass durch die p- bzw. n-Dotierung der Trägerschichten diese bereits als Elektronenakzeptor bzw. -donator an dem photovoltaischen Prozeß teilnehmen. Trägerschichten aus p- und aus n-dotierten Materialien werden direkt übereinander gelegt und mit einem Donatormaterial wie etwa einem konjugierten Polymer benetzt bzw. getränkt. Entsteht bei Bestrahlung mit Licht im Donatormaterial ein Exziton, so erfolgt der Elektronentransfer in diesem Fall direkt von dem Polymer in das (p-dotierte) Akzeptor-Material, genauso werden die Löcher von der Polymerkette auf die Donatorfasern (n-dotiert) abgegeben. Es sind keine weiteren Beschichtungen oder Trägermaterialien notwendig.

In einer ersten bevorzugten Ausgestaltung können die Trägerschichten aus schichtartig angeordneten Fasern gebildet sein, wobei eine Trägerschicht nur Fasern als p-dotierte oder undotierte Elektronenakzeptoren und die andere Trägerschicht nur Fasern als n-dotierte Elektronendonatoren aufweist. Eine derartige Ausbildung der Trägerschichten aus Fasern bietet die Möglichkeit, die mechanische Flexibilität und Verformbarkeit dieser Fasern beispielsweise in ein aus den Fasern gebildetes Gewebe oder ein Vlies einzubringen, indem die Fasern nach ihrer Herstellung in einem derartigen textilen Material verarbeitet werden oder dieses textile Material bilden. Man erhält dadurch eine Art photovoltaisches Gewebe, welches ähnlich wie eine Polymer-Solarzelle arbeitet, aber noch wesentlich flexibler, robuster und vor allem textil verarbeitbar ist. Auch wird hierbei die photovoltaisch wirksame Fläche wesentlich vergrößert und die Effektivität der photovoltaischen Einrichtung verbessert. Ein solches photovoltaische Gewebe, das also bei Sonnenbestrahlung Strom erzeugt, aber vollkommen flexibel, sehr robust, ultraleicht und wie Textilien verarbeitbar ist, kann in vielen Gebieten eingesetzt werden, wie z.B. für funktionelle Bekleidung, für Segelbespannungen, auf Flugzeugtragflächen, Sonnenschirmen, etc..

In weiterer Ausgestaltung sind die Trägerschichten aus Fasern einander zumindest abschnittsweise berührend zueinander angeordnet, wobei die Trägerschichten mit einem Donatormaterial benetzt oder die Fasern jeder Trägerschicht mit dem Donatormaterial beschichtet sind und dadurch die Fasern der p-dotierten oder undotierten Trägerschicht an ihren Berührungsstellen mit dem Donatormaterial photovoltaische Elemente bilden. Das Donatormaterial bildet durch die Beschichtung quasi auf der ganzen Oberfläche der Trägerschicht oder der Fasern, an denen das Donatormaterial und die p-dotierten bzw. undotierten Trägerschichten oder Fasern sich gegenseitig berühren ein photovoltaisches Element, wodurch aufgrund dieser großen Oberfläche der Trägerschicht oder der Fasern die photoelektrisch wirksame Oberfläche einer derart gebildeten photovoltaischen Einrichtung wesentlich gegenüber herkömmlichen photovoltaischen Einrichtungen vergrößert ist.

Die Erfindung gemäß Anspruch 2 geht aus von einer photovoltaischen Einrichtung, aufweisend ein photovoltaisches Akzeptormaterial und ein photovoltaisches Donatormaterial. Eine derartige photovoltaische Einrichtung wird dadurch in erfindungsgemäßer Weise weiter entwickelt, dass die photovoltaische Einrichtung eine Trägerschicht aus einer Anzahl faserartig längserstreckten Trägerelementen, bestehend aus dem Akzeptormaterial, vorzugsweise aus einem p-dotierten oder undotierten Elektronenakzeptor, aufweist und die Trägerelemente der Trägerschicht mit dem photovoltaischen Donatormaterial filmartig benetzt oder beschichtet sind, auf das eine weitere Schicht aus einem vorzugsweise n-dotierten Elektronendonator aufgebracht ist. Hierbei wird der Schichtaufbau der photovoltaischen Einrichtung gemäß Anspruch 1, die aus zwei Trägerschichten besteht, quasi in einer einzelnen Schicht aus einer Anzahl faserartig längserstreckter Trägerelemente realisiert, wobei jedes Trägerelement für sich mit zwei verschiedenen Schichten definierter Dicke umhüllt werden und damit die innenliegende Schicht aus dem Akzeptormaterial und die außenliegende Schicht aus dem Elektronendonator, getrennt durch die Schicht aus dem photovoltaischen Donatormaterial den Schichtaufbau bilden, der zur Gewinnung photovoltaischer Ströme genutzt werden kann. Durch die exakter als bei der Lösungnach Anspruch 1 einstellbaren Schichtdicken, die von der Lage der beiden Trägerschichten wie bei der Lösung nach Anspruch 1 zueinander unabhängig ist, ergeben sich jeweils optimale Abstände der Schicht aus dem Akzeptormaterial von der Schicht aus dem Elektronendonator und damit wird sich ein höherer Wirkungsgrad erreichen lassen.

Hierzu können in einer ersten Ausgestaltung die faserartig längserstreckten Trägerelemente zueinander strukturiert angeordnet sein, beispielsweise als Matte mit sich kreuzenden Fasern. Selbstverständlich sind auch andere Anordnungsformen der Trägerelemente denkbar, z.B. unregelmäßig geformte Gelege oder Gewebe oder dgl.

Von Vorteil ist es, wenn die Trägerelemente der Trägerschicht aus vorzugsweise mit Aluminium dotiertem Siliziumkarbid SiC gebildet sind und darüber hinaus die Schicht aus dem photovoltaischen Donatormaterial die Trägerelemente der Trägerschicht vollflächig umhüllt. Damit lässt sich auf einem geeigneten Akzeptormaterial mit den noch nachstehend beschriebenen Eigenschaften der Abstand zwischen den Trägerelementen der Trägerschicht und der Schicht aus dem n-dotierten Elektronendonator derart durch Variation der Schichtdicke der Schicht aus dem photovoltaischen Donatormaterial einstellen, dass der Wirkungsgrad der photovoltaischen Einrichtung abhängig von den jeweils verwendeten Materialien optimiert werden kann. Von Vorteil ist es hierbei, wenn die Schicht aus dem photovoltaischen Donatormaterial 100 nm Dicke aufweist.

In weiterer Ausgestaltung ist es denkbar, dass die Schicht aus einem n-dotierten Elektronendonator auf der Schicht aus dem photovoltaischen Donatormaterial aus einem transparenten organischen Elektrodenmaterial besteht. Ein derartiges transparentes organisches Elektrodenmaterial wird in der Regel ein transluzentes oder zumindest Licht leitendes Polymerelektroden-Material sein, vorzugsweise aus Polyethylendioxythiophen wie etwa Baytron, das auf die Schicht aus dem photovoltaischen Donatormaterial aufgebracht ist. Dies kann beispielsweise aus einer Suspension erfolgen, etwa mittels Spin-Coating, Dip-Coating oder auch durch Aufsprühen.

Es ergeben sich für die Ausgestaltung der photovoltaischen Einrichtung gemäß Anspruch 2 im wesentlichen die gleichen Eigenschaften und Vorteile, die nachfolgend auch für die photovoltaische Einrichtung gemäß Anspruch 1 noch ausführlicher beschrieben werden.

Von Vorteil ist es weiterhin, dass die Fasern der Trägerschichten aus Fasern textil verarbeitbar sind. Damit stehen für die Weiterverarbeitung der Fasern zur Trägerschicht alle aus dem Bereich textiler Werkstoffe bekannten Verarbeitungsverfahren zur Verfügung und es können durch derart hergestellte Trägerschichten eine Vielzahl von unterschiedlichen textilen Werkstoffen mit jeweils unterschiedlichen und an den Einsatzzweck anpassbaren Eigenschaften gebildet werden. So ist es etwa denkbar, dass in einer ersten Ausgestaltung die Trägerschicht aus Fasern in Form von vliesartig angeordneten kurzen Fasern, insbesondere von Fasern mit maximal 5 mm Länge gebildet ist. Derartige Vliese stellen lose Verbindungen zwischen den eher unstrukturiert zueinander angeordneten Fasern her und bilden leichte, z.B. in ihren Festigkeitseigenschaften sehr weit variierbare Schichten. In einer anderen Ausgestaltung ist es auch denkbar, dass die Trägerschicht aus Fasern in Form von miteinander verwobenen langen Fasern, insbesondere von Fasern mit mehr 5 mm Länge gebildet ist. Hierdurch erschließt sich der photovoltaischen Einrichtung der ganze Bereich gewebter oder sonst wie textil fest miteinander verbundener Fasern, die höhere Festigkeiten aufgrund der Ausrichtung der Fasern zueinander und der Vielzahl der Verbindungen der Fasern untereinander aufweisen können. Weiterhin kann die Trägerschicht auch aus Fasern in Form von miteinander vernetzten, kurzen oder langen Fasern gebildet werden, z.B. indem die Fasern durch nachgelagerte Behandlungsschritte chemisch oder thermisch an den Berührungspunkten miteinander vernetzt oder aneinander festgelegt werden und damit einen zwar gut verformbaren, gleichwohl aber in sich stabilen Verbund bilden.

Von Vorteil ist es, wenn in weiterer Ausgestaltung die Durchmesser der Fasern der Trägerschichten zwischen 20 nm bis zu 100 µm betragen. Hierdurch ist die Festigkeit und Verformbarkeit der Fasern, neben der Eigenfestigkeit der Fasern aufgrund ihres Materials, in weiten Grenzen steuerbar, wodurch sich die Festigkeitseigenschaften daraus hergestellter Gewebe entsprechend beeinflussen lassen.

In einer anderen Ausgestaltung ist es auch denkbar, dass die Trägerschichten aus einer dünnen homogenen Schicht des n-dotierten Elektronendonors und einer dünnen homogenen Schicht des p-dotierten oder undotierten Elektronenakzeptors bestehen. Derartige homogene, etwa folienartig ausgebildete Schichten weisen zwar nicht die Vorteile aus Fasern gebildeter textiler Strukturen auf, haben aber ebenfalls eine gewisse Verformbarkeit. Zur Erhöhung der Festigkeit können die dünnen homogenen Schichten auf einem mechanisch belastbaren Trägermaterial aufgebracht sein, der selbst höhere Festigkeitswerte als die dünnen homogenen Schichten aufweist.

In einer alternativen Ausgestaltung ist es auch denkbar, dass die Trägerschichten aus einer dünnen porösen Struktur des n-dotierten Elektronendonors und einer dünnen porösen Struktur des p-dotierten oder undotierten Elektronenakzeptors bestehen. Eine poröse Struktur bietet ebenfalls die Möglichkeit, eine gewisse mechanische Flexibilität mit den vorteilhaften Eigenschaften der beschriebenen Schichtaufbaus zu kombinieren.

Von Vorteil für die Verwendung der photovoltaischen Einrichtung ist es, dass die Kontaktierung der Schichten des Schichtaufbaus zur Ableitung der gewonnenen Ladungen an beliebiger Stelle der Schichten erfolgen kann. Hierdurch ist es beispielsweise bei einem Gewebe z.B. bei einer Markise oder dgl. möglich, an passender Stelle die Kontaktierung zu realisieren, ohne dass Nachteile durch die Kontaktierung hinsichtlich des Gebrauches des textilen Gewebes hervorgerufen werden. Vorteilhaft ist es beispielsweise, wenn die Kontaktierung der aus Fasern gebildeten Schichten an Nähten von aus den Schichten gebildeter textiler Materialien erfolgt, an denen ohnehin entsprechende Verarbeitungsschritte vorgenommen werden.

Weiterhin ist es denkbar, dass in die Schichten elektronische Bauelemente integriert sind, die etwa besondere Aufgaben bei der Gewinnung der elektrischen Spannung der photovoltaischen Einrichtung übernehmen können.

Hinsichtlich der Materialien für den Elektronenakzeptor und den Elektronendonator können unterschiedlichste Materialien zum Einsatz kommen, Von Vorteil ist es, wenn als Material für den p-dotierten oder undotierten Elektronenakzeptor transparente Halbleitermaterialien, insbesondere organische oder anorganische Halbleitermaterialien, vorzugsweise ZnO, TiO₂ verwendbar sind.

Als besonders günstig hat es sich heraus gestellt, wenn als Material für die Trägerschicht mit dem p-dotierten oder undotierten Elektronenakzeptor Siliziumkarbid SiC verwendet wird. In weiterer Ausgestaltung kann das Siliziumkarbid SiC auch als Material für die Trägerschicht mit dem n-dotierten Elektronendonor verwendet werden. Hierbei ist es auch denkbar, das Siliziumkarbid SiC als Siliziumkarbid-Einkristall, vorzugsweise als monokristallines kubisches 3C-SIC zu verwenden. Insbesondere die einkristallinen Siliziumkarbid-Fasern vereinen die hervorragenden Eigenschaften des Minerals, wie u.a. hohe Härte, optische Transparenz, Halbleiter-Charakter, hohe thermische Leitfähigkeit, chemische und thermische Haltbarkeit mit der Flexibilität der Fasern, wie sie für die Fertigung eines Gewebes nötig sind. Siliziumkarbid-Gewebe kann auch für Schutzkleidung (gegen Stich-, Schneid- und Schussverletzungen), Schutzbespannungen oder -hüllen in vielen Bereichen genutzt werden. Ein Gewebe aus Siliziumkarbid-Fasern mit einem konjugierten Polymer zu benetzen bringt mehrere Vorteile. Zum einen stellt ein SiC-Gewebe ein sehr flexibles und haltbares Trägermaterial dar, zum anderen nimmt es durch die p- bzw. n-Dotierung der Fasern bereits als Elektronenakzeptor bzw. -donator an dem photovoltaischen Prozess teil. Gewebe aus p- und aus n-dotierten SiC-Fasern werden direkt übereinander gelegt und mit einem konjugierten Polymer benetzt/getränkt. Entsteht bei Bestrahlung mit Licht im konjugierten Polymer ein Exziton, so erfolgt der Elektronentransfer in diesem Fall direkt von dem Polymer in die p-dotierten Akzeptor-Fasern, genauso werden die Löcher von der Polymerkette auf die n-dotiert oder undotierten DonatorFasern abgegeben. Man hat ein leichtes, einfach zu verarbeitendes stromerzeugendes Gewebe, verwendbar für Bespannungen von Markisen, Rollos, Sonnenschirmen, Kleidung, Gardinen, Abdeckplanen, Flugzeug-Tragflächen und vieles mehr. Ein derartiges Siliziumkarbid-Gewebe an sich ist auch für Schutzkleidung (gegen Stich-, Schneid- und Schussverletzungen), Schutzbespannungen oder -hüllen in vielen Bereichen geeignet. Neben den hervorragenden elektronischen Eigenschaften von Siliziumkarbid kommen diesem Material noch weitere Vorteile zugute, wie große chemische und thermische Stabilität. Es ist das härteste Material nach Diamant und besitzt eine hohe thermische Leitfähigkeit. Es ist damit auch mechanisch sehr beanspruchbar oder kann in aggressiver oder Hochtemperaturumgebung eingesetzt werden.

Bei der Verwendung von Siliziumkarbid 3C-SiC als Material für die Fasern aus monokristallinem Siliziumkarbid SiC werden die Fasern mit einem vollen Querschnitt und sechseckiger Umfangsform gebildet. Hierdurch ist eine sehr stabile Faserbildung gewährleistet.

Denkbar ist es auch, dass das Siliziumkarbid SiC als poröses Siliziumkarbid oder als polykristallines Siliziumkarbid verwendbar ist.

In einer weiteren Ausgestaltung ist es denkbar, dass als Material für die Trägerschicht mit dem n-dotierten Elektronendonor transparente Leitermaterialien, vorzugsweise ITO, ATO, AZO oder dgl. Leitermaterialien verwendet werden.

Von besonderem Vorteil ist es, wenn das photovoltaische Donatormaterial ein konjugiertes Polymer ist. Derartige konjugierte Polymere, beispielsweise P3HT (poly-(3-hexylthiophen)), MDMO-PPV (poly(2-methoxy-5-(3',7'-dimethyloctyloxy)-1,4-phenylen-vinylen)), MEH-PPV (poly(2,5-dialkoxy-para-phenylen-vinylen)) und PFB (poly(9,9'-dioctylfluoren-co-bis-N,N'-(4-butylphenyl)-bis-N,N'-phenyl-1,4-phenylendiamin)) haben vorteilhafte photoelektrische Eigenschaften und sind bekannt und daher technisch weitgehend beherrschbar. Wichtig ist hierbei vor allem, dass das photovoltaische Donatormaterial als Donatormaterial ausgebildet ist, das sich als Film auf die Trägerschicht aufbringen lässt. Durch die Filmbildung auf den Trägerschichten oder auf den Fasern der Trägerschichten lassen sich die photoelektrischen Eigenschaften weitgehend steuern und beeinflussen.

Die Erfindung betrifft weiterhin ein Verfahren zur Herstellung von Fasern für Trägerschichten zur Bildung einer photovoltaischen Einrichtung, insbesondere einer photovoltaischen Einrichtung gemäß Anspruch 1, bei dem in einem ersten Schritt die zu verarbeitenden Materialien bei einer Sol-Gel-Synthese miteinander eine Mischung in Form eines Gels bilden, und in einem weiteren Schritt in einer carbothermalen Reduktion das Wachsen der Fasern abläuft. Der an sich bekannte Sol-Gel-Prozess bietet eine gut beherrschbare und weit variierbare Möglichkeit der Herstellung unterschiedlichster Ausgangsmaterialien für die Herstellung der erfindungsgemäßen Trägerschichten oder von deren Vormaterialien. Hierbei läuft in weiterer Ausgestaltung die Sol-Gel-Synthese unter Einsatz von Tetraethylorthosilikat, Ethanol, Salzsäure und Saccharose ab.

Von Vorteil ist es, wenn die Dotierungsmaterialien im nasschemischen Teil der Sol-Gel-Synthese eingebracht werden, wodurch die Dotierungsmaterialien während der thermischen Behandlung in die wachsenden Fasern eingebaut werden. Die Dotierungsmaterialien können hierbei entweder als lösliche Verbindung beigegeben werden oder metallisch addiert werden. Alternativ ist es aber auch denkbar, dass die Dotierung der sich bildenden Fasern während der thermischen Behandlung über die Gasphase vorgenommen wird. Als Dotierungsmaterialien können bevorzugt Phosphor P, Stickstoff N, Bor B und/oder Aluminium AI oder deren Verbindungen verwendet werden.

Hinsichtlich der Beeinflussung des Verfahrens und von dessen Erzeugnissen bei Verwendung von Siliziumkarbid SiC ist es von Vorteil, dass die bei der thermischen Behandlung eingestellte Temperatur die Kristallisierungsart der Fasern des Siliziumkarbid SiC beeinflusst. Durch Variation der Temperatur der thermischen Behandlung der aus dem Sol-Gel-Prozess gewonnenen Fasern kann damit eine Variation der entstehenden Kristallstrukturen des Siliziumkarbid SiC erreicht werden.

Eine weitere Möglichkeit der Beeinflussung der Eigenschaften einer aus Fasern gebildeten Trägerschicht ergibt sich, wenn die gebildeten Fasern bei einer Nachbehandlung in einem erneuten Sol-Gel-Verfahren miteinander vernetzt werden. Hierdurch wird aus den Einzelfasern durch die Vernetzung im Bereich der Berührungspunkte einzelner oder einer Vielzahl von Fasern ein fester und gleichwohl flexibler Verbund der Fasern gebildet, ohne dass mittels textiler Bearbeitungsschritte die fasern miteinander verbunden werden müssen.

Von weiterem Vorteil ist es, dass das photovoltaische Donatormaterial auf die Trägerschichten in einer Lösung aufgebracht werden kann. Insbesondere wenn durch den Verdünnungsgrad in der Lösung des photovoltaischen Donatormaterials die Schichtdicke bei der Ablagerung auf der Trägerschicht gesteuert werden kann, lässt sich verfahrenstechnisch eine einfache Beeinflussung der photovoltaischen Eigenschaften der aus den Trägerschichten und dem Donatormaterial gebildeten photovoltaischen Einrichtung erreichen.

Eine weitere Verbesserung lässt sich erreichen, wenn bei Schichtdicken des Akzeptormaterials von mehr als 100 nm zusätzlich Fullerene, Kohlenstoffnanoröhrchen, TiO₂-Nanokristalle oder SiC-Nanokristalle in das Akzeptormaterial eingelagert werden, die zusätzlich zu dem Akzeptormaterial die Rekombination der Exzitonen verhindern und diese an sich binden.

Die Erfindung beschreibt weiterhin ein Verfahren zur Herstellung eines Schichtaufbaus für eine photovoltaische Einrichtung gemäß Anspruch 1, bei dem mindestens eine der beiden Trägerschichten mit dem flüssigen Donatormaterial benetzt oder getränkt wird und im noch flüssigen Zustand des Donatormaterials mit der anderen Trägerschicht in zumindest abschnittsweise flächig berührenden Kontakt gebracht wird, wobei durch Aushärten des flüssigen Donatormaterials die beiden Trägerschichten einander abschnittsweise berührend, dauerhaft aneinander festgelegt werden. Hierdurch lässt sich gleichzeitig durch das Tränken oder benetzen der Trägerschichten mit dem Donatormaterial eine feste Verbindung zwischen den mindestens zwei Trägerschichten erreichen, die nach dem Aushärten des vorteilhaft als konjugiertes Polymer ausgebildeten Donatormaterials fest aneinander festgelegt sind.

Eine besonders bevorzugte Ausführungsform der erfindungsgemäßen photovoltaischen Einrichtung zeigt die Zeichnung.

Es zeigen:
- Figur 1a-1c: - eine schematische Darstellung des Ablaufs einer Herstellung des Schichtaufbaus einer erfindungsgemäßen photovoltaischen Einrichtung,
- Figur 2a-2c: - Detailvergrößerungen in Berührungsbereich zweier fasern der Trägerschichten einer erfindungsgemäßen photovoltaischen Einrichtung gemäß Figur 1,
- Figur 3a-3d: - Photovoltaische Vorgänge in einer erfindungsgemäß aufgebauten photovoltaischen Einrichtung gemäß Figur 1 bei Einstrahlung von Licht,
- Figur 4: - eine vergrößerte Darstellung einer Anordnung von SiC-Fasern als Vorprodukt für eine Trägerschicht,
- Figur 5: - eine vergrößerte Darstellung einer nachbehandelten Anordnung von SiC-Fasern mit Vernetzungsstellen an Faserkreuzungen,
- Figur 6: - eine schematische Darstellung des Querschnittes durch eine Anordnung von Trägerelementen einer aus sich kreuzenden Fasern gebildeten Trägerschicht gemäß Anspruch 2.

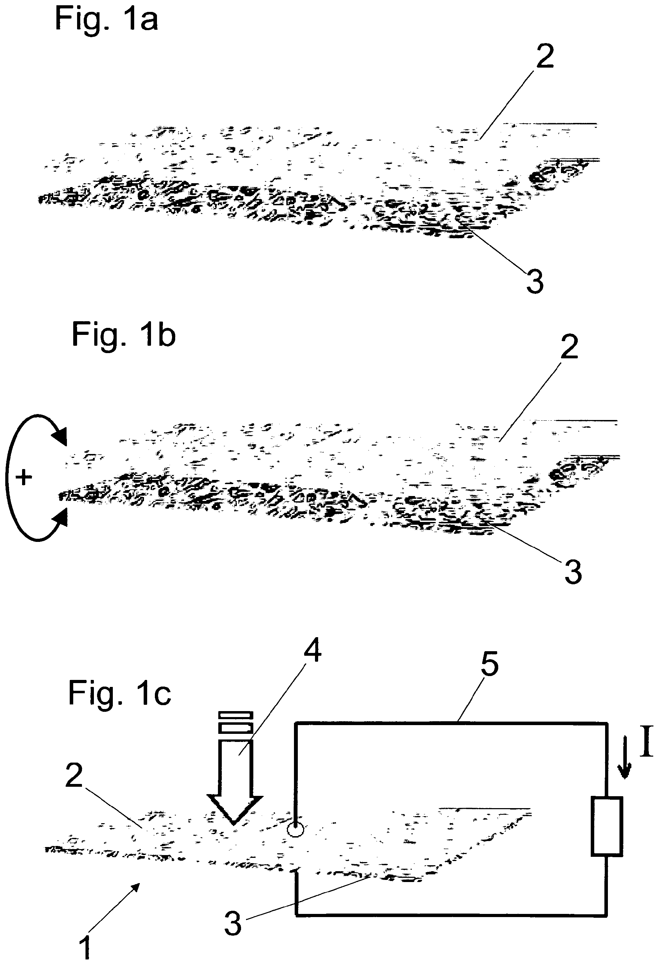

In den Figuren 1a bis 1c ist in einer schematischen Darstellung der Ablauf einer Herstellung des Schichtaufbaus einer erfindungsgemäßen photovoltaischen Einrichtung 1 dargestellt, die aus zwei Tragerschichten 2, 3 aus Siliziumkarbid-Fasern (SiC) mit unterschiedlichen Dotierungen gebildet wird. Hierzu werden, wie nachstehend noch näher ausgeführt, Trägerschichten 2, 3 aus SiC-Fasern hergestellt, bei denen die Fasern z.B. als vliesartige Struktur vorliegen, wobei die Fasern sich an einer Vielzahl von Punkten berühren und daher die Trägerschichten 2, 3 eine entsprechende Festigkeit aufweisen. Eine der Trägerschichten 2 wird dabei als Elektronen-Akzeptor ausgebildet, die andere Trägerschicht 3 n-dotiert oder auch undotiert als Elektrode ausgebildet. Die entsprechende Dotierung erhalten die Fasern aus SiC innerhalb eines Sol-Gel-Prozesses, nach dem die Fasern aus dem Gel unter thermischer Reduktion gebildet werden und beim Kristallwachstum der bevorzugt monokristallinen Fasern die Dotierungsmaterialien eingelagert werden.

Durch die unterschiedliche Dotierung der beiden Trägerschichten 2, 3 kann gemeinsam mit einem hier als konjugiertes Polymer ausgebildeten Donatormaterial 10 eine photovoltaische Einrichtung 1 aufgebaut werden, wozu das Donatormaterial 10, die p-dotierte Trägerschicht 2umhüllend zwischen die beiden Trägerschichten 2, 3 gebracht wird. Hierzu können entweder die übereinander angeordneten Trägerschichten 2, 3 mit dem Donatormaterial 10 getränkt werden, wodurch sich das Donatormaterial 10 an den Fasern 6, 7 der beiden unterschiedlichen Trägerschichten 2, 3 anlagert und damit an den Berührungsstellen von Donatormaterial 10 und p- bzw. undotierten Fasern 7 ein photovoltaisches Element gebildet wird. Eine andere Vorgehensweise besteht darin jede der beiden Trägerschichten 2, 3 mit dem Donatormaterial 10 zu benetzen, so dass die Fasern 6, 7 der Trägerschichten 2, 3 von dem Donatormaterial 10 umhüllt werden. Im noch feuchten Zustand des üblicherweise flüssigen Donatormaterials 10 werden die Trägerschichten 2, 3 dann aufeinander gelegt und miteinander verpresst, wodurch die Fasern 6, 7 der unterschiedlichen Trägerschichten 2, 3 sich unter Zwischenlage des Donatormaterials 10 punktuell aufeinander legen. Nach dem Aushärten des Donatormaterials 10 sind die beiden Trägerschichten 2, 3 dann dauerhaft aneinander festgelegt und können als Einheit gehandhabt werden.

Wird nun an den beiden Trägerschichten 2, 3 eine Kontaktierung nach außen angeschlossen, so kann die in der photovoltaischen Einrichtung 1 gebildete Spannung abgenommen werden.

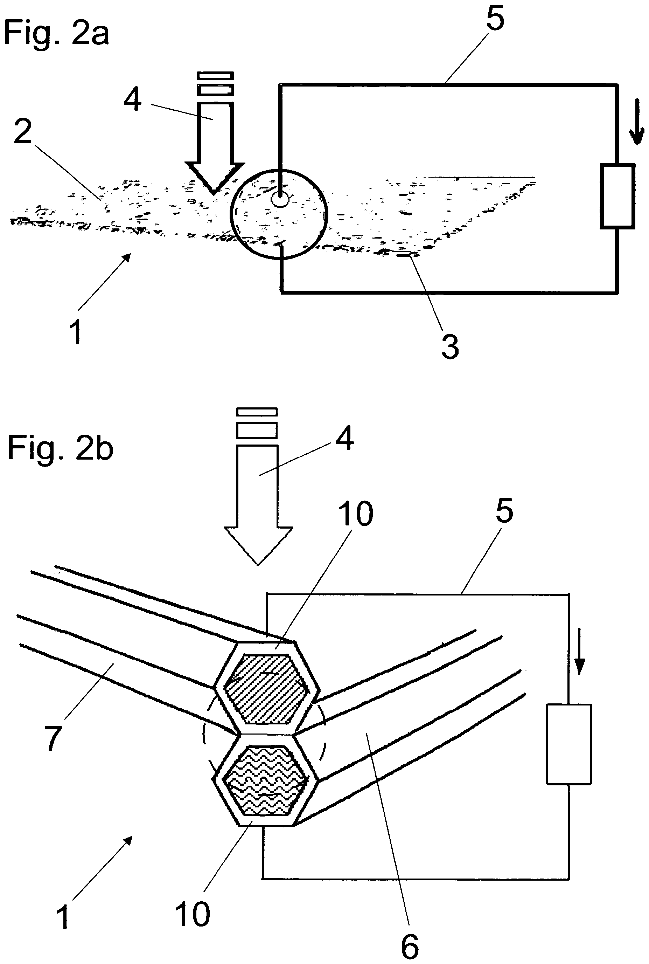

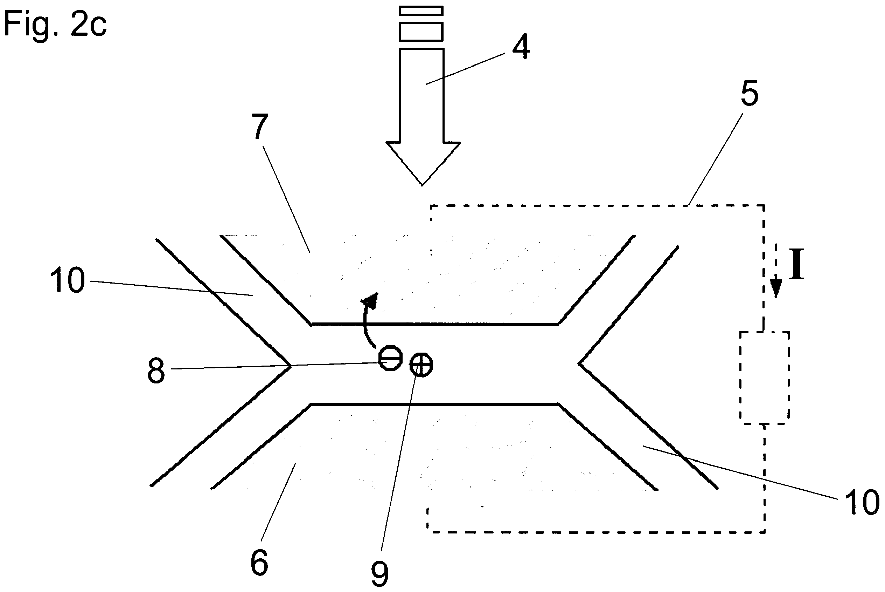

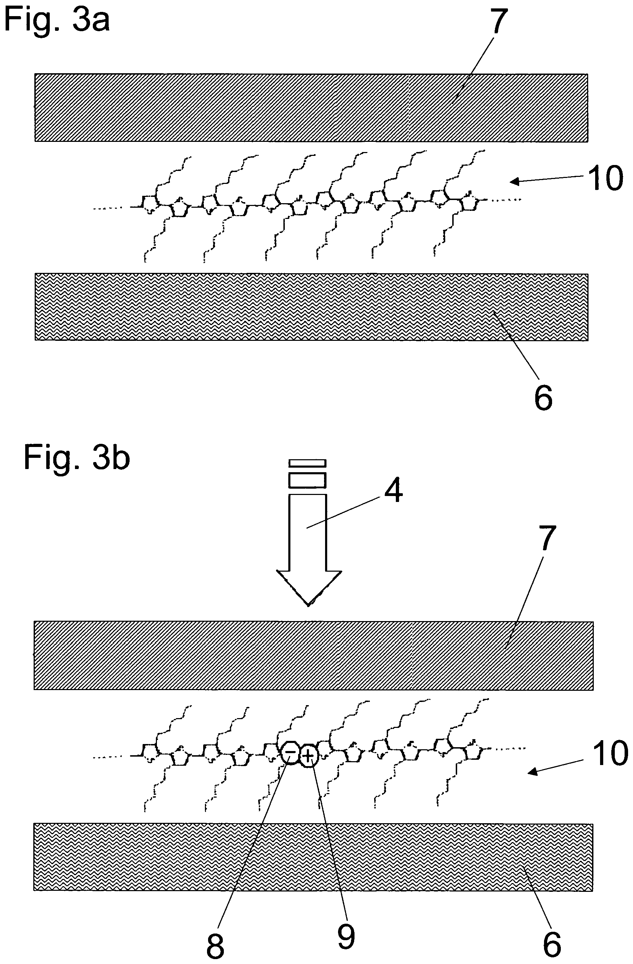

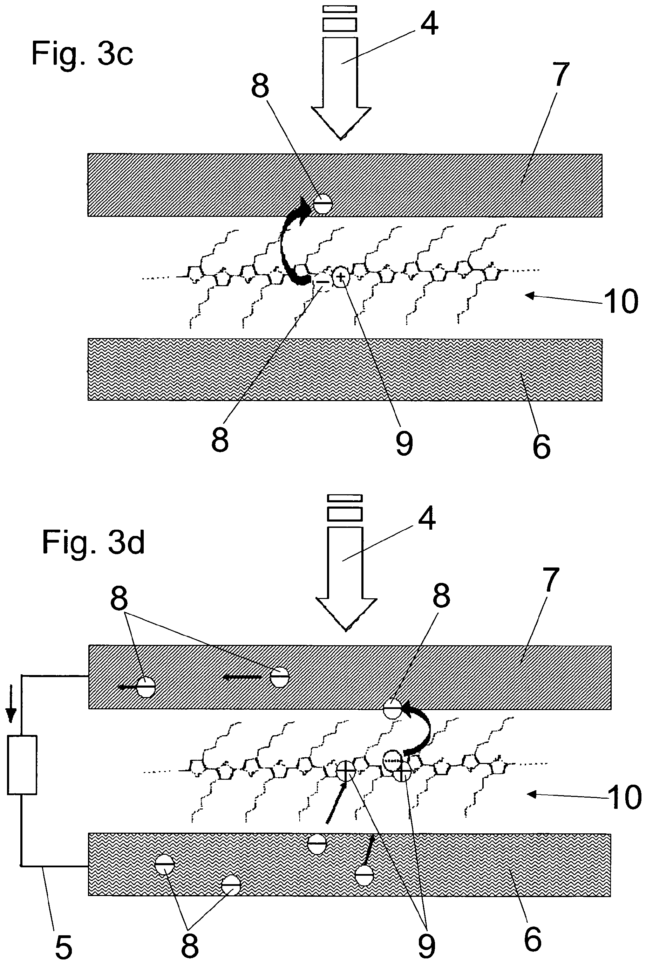

In den Figuren 2a bis 2c sind nun in Detailvergrößerungen die an den Berührungsstellen der Fasern 6, 7 der unterschiedlichen Trägerschichten 2, 3 ablaufenden Prozesse dargestellt. Die Figur 2 a entspricht der Figur 1c und ist nur der Übersichtlichkeit halber noch einmal aufgenommen. In der Berührungszone der beiden Trägerschichten 2, 3 kommt es zu einzelnen Berührung der Fasern 6, 7 der beiden Trägerschichten 2, 3, wie dies in Figur 2b dargestellt ist. Die SiC-Faser 7 der oberen Trägerschicht 2 liegt dabei punktuell bzw. kleinflächig auf der SiC-Faser 6 der unteren Trägerschicht 3 auf, wobei zwischen den beiden Fasern 6, 7 das Donatormaterial 10 hier in Form eines konjugierten Polymers angeordnet ist (Figur 3a). Fällt nun Licht 4 auf die mit dem Donatormaterial 10 ummantelte und p- bzw. undotierte SiC-Faser 6, so bilden sich in dem konjugierten Polymer 10 durch Absorption von Licht 4 in an sich bekannter Weise Exzitonen (Elektron-Loch-Paare), wie dies in der Figur 3b noch einmal schematisch als ein Ablaufschema dargestellt ist. Durch die starke Bindung des Elektrons 8 an das Polymer 10 hat das Exziton eine relativ kleine Diffusionslänge (Abstand des Elektrons 8 zum auf der Polymer-Kette verbliebenen Loch 9) von etwa 100nm und rekombiniert relativ schnell. Da aber für photovoltaische Anwendungen eine möglichst lange Lebensdauer des photoinduzierten Zustands von Vorteil ist, benötigt man ein Akzeptormaterial, welches im Diffusionsbereich des Exzitons diese Elektronen 8 abfangen und so am Rekombinieren hindern soll. Dieses Akzeptormaterial in Form des p-dotierten SiC ist in einer Entfernung zu dem Entstehungsort des Exzitons angeordnet, den das Elektron 8 überwinden kann und damit in das Akzeptormaterial 7 übergeht (Figur 3c). Hierfür muss die Schichtdicke des Donatormaterials 10 auf die Diffusionslänge des Exzitons abgestimmt sein. Das Elektron 8 tritt in das n-dotierte oder undotierte SiC-Material 6 über, wodurch sich der in der Figur 3d dargestellte Stromkreis 5 ergibt.

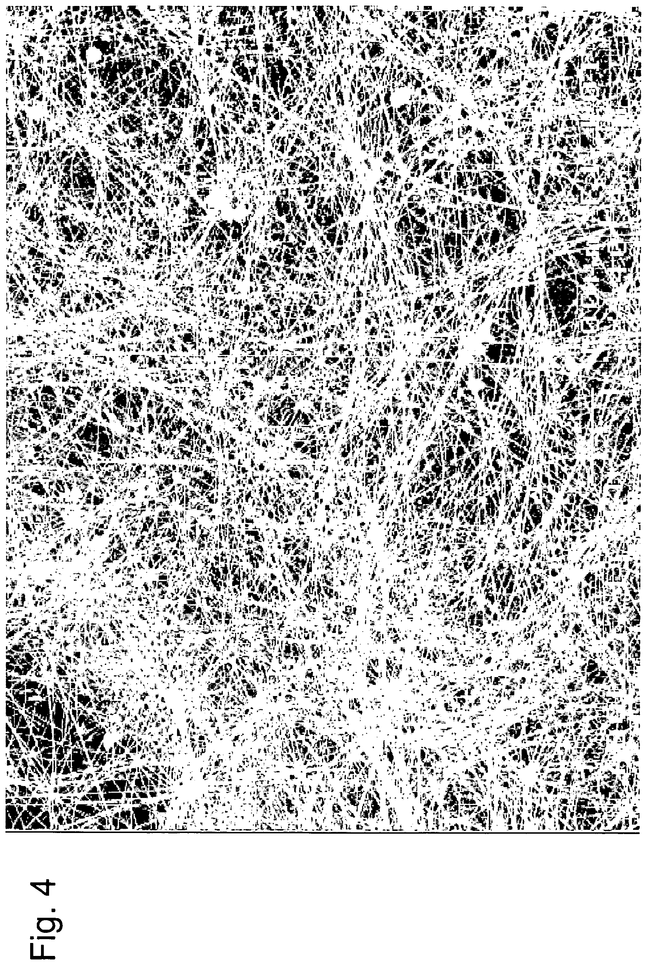

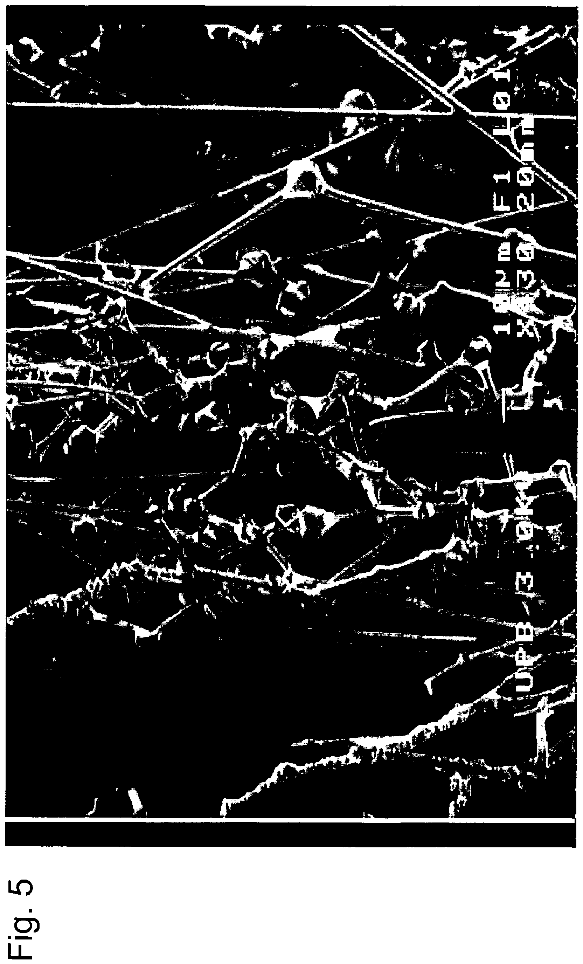

Beispiele für die Struktur einer aus Fasern 6, 7 aus SiC gebildeten Trägerschicht 2, 3 in Form einer vliesartigen Anordnung der Fasern 6, 7 lassen sich aus den Figuren 4 und 5 erkennen. Hierbei ist in der Figur 4 in einer stark vergrößerten Ansicht eine aus kurzen Fasern 6, 7 gebildete Struktur zu erkennen, bei der die Fasern 6, 7 wie bei einem Vlies in unterschiedlichsten Richtungen orientiert als eine Art Haufwerk vorliegt und damit nur relativ schwach miteinander verbunden sind. Durch an sich bekannte textile Verarbeitungsprozesse können derartige Fasern 6, 7 gerichtet und aneinander besser festgelegt werden. Hierdurch lassen sich vielfältige Einsatzzwecke derartiger Trägerschichten 2, 3 erschließen, da immer dort, wo textile Gewebe oder Strukturen Licht 4 ausgesetzt sind, auch eine photovoltaische Einrichtung 1 der erfindungsgemäßen Art vorgesehen werden können.

In der Figur 5 ist in einer weiter vergrößerten Darstellung eine andere Art der Festlegung der Fasern 6, 7 der Trägerschichten 2, 3 aneinander erkennbar, bei der die Fasern 6, 7 einer Trägerschicht 2, 3 durch einen nachgeschalteten weiteren Sol-Gel-Prozess an ihren Berührungspunkten miteinander vernetzt werden und dadurch die Struktur der Fasern 6, 7 fester miteinander verbunden ist. Hierdurch erübrigen sich nachfolgende textile Verarbeitungsvorgänge der Fasern 6, 7 ganz oder teilweise.

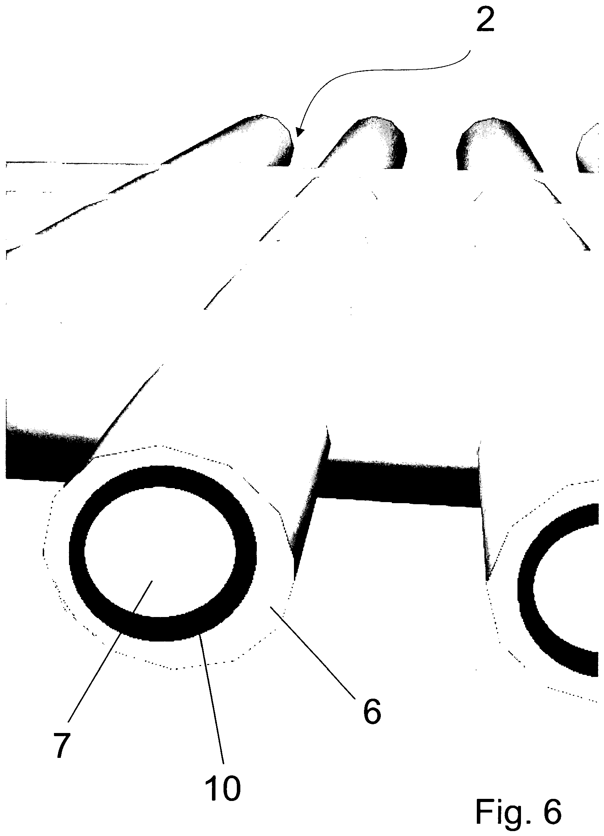

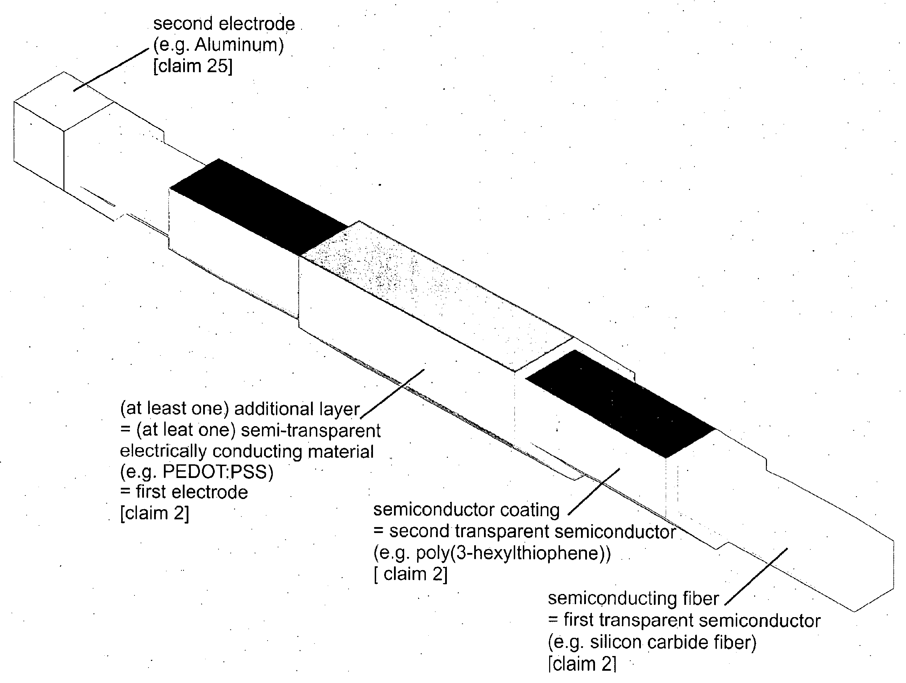

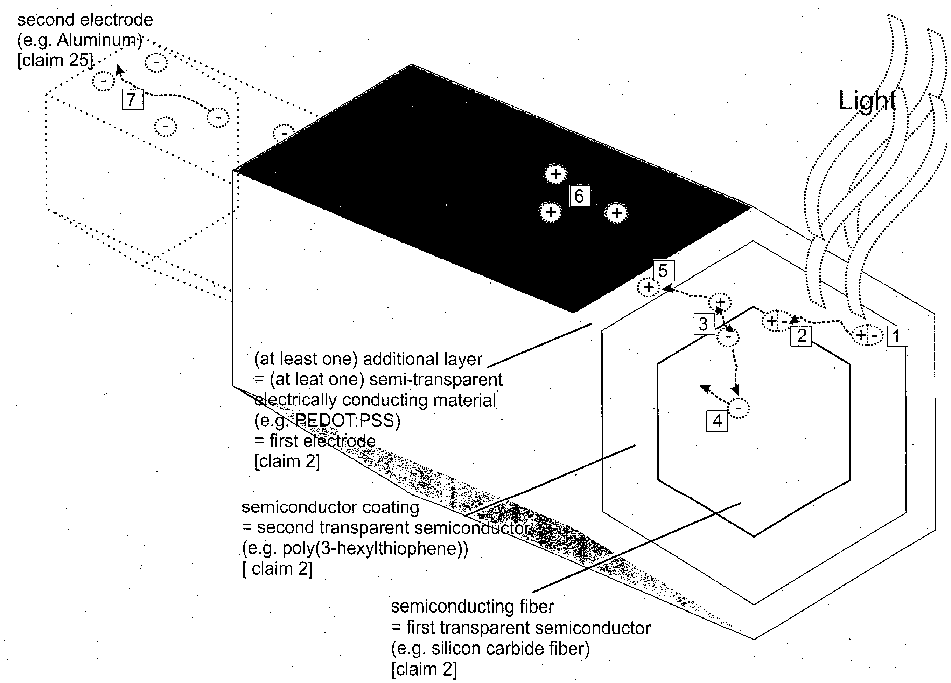

In der Figur 6 ist in einer sehr schematischen Darstellung der Querschnitt durch eine Anordnung von Trägerelementen einer aus sich kreuzenden Fasern gebildeten Trägerschicht (2) gemäß Anspruch 2 dargestellt, wobei die Trägerschicht (2) aus einer Anzahl faserartig längserstreckten Trägerelementen aus dem Akzeptormaterial (7) besteht und die Trägerelemente der Trägerschicht (2) mit dem photovoltaischen Donatormaterial (10) filmartig benetzt oder beschichtet sind. Auf die Schicht mit dem photovoltaischen Donatormaterial (10) ist eine weitere Schicht aus einem Elektronendonator aufgebracht, wobei diese drei Schichten dann für jedes Trägerelement separat die schon beschriebene photovoltaisch wirksame Anordnung bilden. Von Vorteil ist hierbei insbesondere die genaue Einstellbarkeit der jeweiligen Schichtdicken, durch die die photovoltaischen Eigenschaften der Trägerelemente gut kontrollierbar und optimierbar werden und unabhängig von der Lage einzelner Schichten der Ausgestaltung gemäß Figur 1 werden. Die Trägerelemente können hierbei wie in Figur 6 dargestellt sich kreuzende Anordnungen annehmen, denkbar ist aber auch jede andere Anordnung der Trägerelemente zueinander.

### Sachnummernliste

- 1: - photovoltaische Einrichtung
- 2: - p-dotierte oder undotierte Trägerschicht
- 3: - n-dotierte Trägerschicht
- 4: - Licht
- 5: - Stromkreis
- 6: - Elektrode
- 7: - Akzeptor
- 8: - Elektron
- 9: - Loch
- 10: - Donator/konjugiertes Polymer

## Patentansprüche

1. Photovoltaische Einrichtung (1), aufweisend ein photovoltaisches Akzeptormaterial (7) und ein photovoltaisches Donatormaterial (10),
**dadurch gekennzeichnet, dass**
die photovoltaische Einrichtung (1) mindestens zwei Trägerschichten (2, 3) aus Fasern halbleitender Materialien aufweist, von denen eine Trägerschicht (3) n-dotierte Elektronendonatoren und die andere Trägerschicht (2) Akzeptormaterial als p-dotierte oder undotierte Elektronenakzeptoren aufweist, wobei die Trägerschichten (2, 3) einander zumindest abschnittsweise berührend zueinander angeordnet sind und mindestens eine Trägerschicht (2, 3) mit einem photovoltaischen Donatormaterial (10) filmartig benetzt oder beschichtet sind, wobei bei Bestrahlung der photovoltaischen Einrichtung (1) mit Licht im Donatormaterial Exzitonen entstehen und der Transfer der Elektronen direkt von dem photovoltaischen Donatormaterial (10) in die Trägerschicht (2) aus dem p-dotierten oder undotierten Elektronenakzeptor und der Transfer der Löcher in die Trägerschicht (3) aus dem n-dotierten Elektronendonator erfolgt.

2. Photovoltaische Einrichtung (1), aufweisend ein photovoltaisches Akzeptormaterial (7) und ein photovoltaisches Donatormaterial (10),
**dadurch gekennzeichnet, dass**
die photovoltaische Einrichtung (1) eine Trägerschicht (2) aus einer Anzahl faserartig längserstreckten Trägerelementen aus halbleitenden Materialien, bestehend aus dem Akzeptormaterial (7) aus einem p-dotierten oder undotierten Elektronenakzeptor aufweist und die Trägerelemente der Trägerschicht (2) mit dem photovoltaischen Donatormaterial (10) filmartig benetzt oder beschichtet sind, auf das eine weitere Schicht (6) aus einem vorzugsweise n-dotierten Elektronendonator aufgebracht ist, wobei bei Bestrahlung der photovoltaischen Einrichtung (1) mit Licht im Donatormaterial Exzitonen entstehen und der Transfer der Elektronen direkt von dem photovoltaischen Donatormaterial (10) in das Akzeptormaterial (7) der Trägerschicht (2) aus dem p-dotierten oder undotierten Elektronenakzeptor und der Transfer der Löcher in die Schicht (6) aus einem vorzugsweise n-dotierten Elektronendonator erfolgt.

3. Photovoltaische Einrichtung (1) gemäß Anspruch 1, **dadurch gekennzeichnet, dass** die Trägerschichten (2, 3) aus schichtartig angeordneten Fasern (6, 7) gebildet sind, wobei eine Trägerschicht (7) nur Fasern (7) als p-dotierte oder undotierte Elektronenakzeptoren und die andere Trägerschicht (6) nur Fasern (6) als n-dotierte Elektronendonatoren aufweist.

4. Photovoltaische Einrichtung (1) gemäß Anspruch 3, **dadurch gekennzeichnet, dass** die Trägerschichten (2, 3) aus Fasern (6, 7) einander zumindest abschnittsweise berührend zueinander angeordnet sind, wobei die Trägerschichten (2, 3) mit einem Donatormaterial (10) benetzt oder die Fasern (6, 7) jeder Trägerschicht (2, 3) mit dem Donatormaterial (10) beschichtet sind.

5. Photovoltaische Einrichtung (1) gemäß Anspruch 2, **dadurch gekennzeichnet, dass** die faserartig längserstreckten Trägerelemente zueinander strukturiert angeordnet sind, vorzugsweise als Matte mit sich kreuzenden Fasern ausgebildet sind.

6. Photovoltaische Einrichtung (1) gemäß einem der vorstehenden Ansprüche, **dadurch gekennzeichnet, dass** die Trägerelemente der Trägerschicht (2) aus, vorzugsweise mit Aluminium dotiertem, Siliziumkarbid SiC gebildet sind.

7. Photovoltaische Einrichtung (1) gemäß einem der vorstehenden Ansprüche, **dadurch gekennzeichnet, dass** die Trägerschichten (2, 3) aus einer dünnen porösen Struktur des n-dotierten Elektronendonators und einer dünnen porösen Struktur des p-dotierten oder undotierten Elektronenakzeptors bestehen.

8. Photovoltaische Einrichtung (1) gemäß einem der Ansprüche 2 bis 4, **dadurch gekennzeichnet, dass** die Fasern (6, 7) der Trägerschichten (2, 3) aus Fasern (6, 7) textil verarbeitbar sind, insbesondere in Form von vliesartig angeordneten kurzen Fasern (6, 7), vorzugsweise mit maximal 5 mm Länge, oder in Form von miteinander verwobenen langen Fasern (6, 7), vorzugsweise mit mehr als 5 mm Länge.

9. Photovoltaische Einrichtung (1) gemäß einem der vorstehenden Ansprüche, **dadurch gekennzeichnet, dass** als Material für die Trägerschicht (2) mit dem p-dotierten oder undotierten Elektronenakzeptor (7) Siliziumkarbid SiC verwendbar ist.

10. Photovoltaische Einrichtung (1) gemäß einem der vorstehenden Ansprüche, **dadurch gekennzeichnet, dass** als Material für die Trägerschicht (3) mit dem n-dotierten Elektronendonor Siliziumkarbid SiC verwendbar ist.

11. Photovoltaische Einrichtung (1) gemäß einem der Ansprüche 9 oder 10, **dadurch gekennzeichnet, dass** das Siliziumkarbid SiC als Siliziumkarbid-Einkristall, vorzugsweise als monokristallines kubisches 3C-SiC verwendbar ist.

12. Photovoltaische Einrichtung (1) gemäß einem der Ansprüche 9 oder 10, **dadurch gekennzeichnet, dass** das Siliziumkarbid SiC als poröses Siliziumkarbid, insbesondere als polykristallines Siliziumkarbid verwendbar ist.

13. Verfahren zur Herstellung von Fasern (6, 7) für Trägerschichten (2, 3) zur Bildung einer photovoltaischen Einrichtung (1), insbesondere einer photovoltaischen Einrichtung (1) gemäß Anspruch 1,
**dadurch gekennzeichnet, dass**
in einem ersten Schritt die zu verarbeitenden Materialien bei einer Sol-Gel-Synthese miteinander eine Mischung in Form eines Gels bilden, und in einem weiteren Schritt in einer carbothermalen Reduktion das Wachsen der Fasern (6, 7) abläuft.

14. Verfahren nach Anspruch 13, **dadurch gekennzeichnet, dass** die Sol-Gel-Synthese unter Einsatz von Tetraethylorthosilikat, Ethanol, Salzsäure und Saccharose abläuft.

15. Verfahren nach einem der Ansprüche 13 oder 14, **dadurch gekennzeichnet, dass** die Dotierungsmaterialien im nasschemischen Teil der Sol-Gel-Synthese eingebracht werden, wobei die Dotierungsmaterialien während der thermischen Behandlung in die wachsenden Fasern (6, 7) eingebaut werden, insbesondere während der thermischen Behandlung über die Gasphase.

16. Verfahren nach einem der Ansprüche 13 bis 15, **dadurch gekennzeichnet, dass** die Fasern (6, 7) aus Siliziumkarbid SiC, vorzugsweise aus kubischem 3C-SiC, besonders vorzugsweise aus monokristallinem Siliziumkarbid SiC gebildet werden:

17. Verfahren nach einem der Ansprüche 13 bis 16, **dadurch gekennzeichnet, dass** bei Schichtdicken des Akzeptormaterials (7) von mehr als 100 nm zusätzlich Fullerene, Kohlenstoffnanoröhrchen, TiO₂-Nanokristalle oder SiC-Nanokristalle in das Akzeptormaterial eingelagert werden.

18. Verfahren zur Herstellung eines Schichtaufbaus für eine photovoltaische Einrichtung (1) gemäß Anspruch 1,
**dadurch gekennzeichnet, dass**
mindestens eine der beiden Trägerschichten (2, 3) mit dem flüssigen Donatormaterial (10) benetzt oder getränkt wird und im noch flüssigen Zustand des Donatormaterials (10) mit der anderen Trägerschicht (3, 2) in zumindest abschnittsweise flächig berührenden Kontakt gebracht wird, wobei durch Aushärten des flüssigen Donatormaterials (10) die beiden Trägerschichten (2, 3) einander abschnittsweise berührend, dauerhaft aneinander festgelegt werden.

## Claims

1. Photovoltaic device (1) comprising a photovoltaic acceptor material (7) and a photovoltaic donor material (10),
**characterised in that**
the photovoltaic device (1) has at least two carrier layers (2, 3) made of fibres of semiconducting materials, of which one carrier layer (3) has n-doped electron donors and the other carrier layer (2) has acceptor material as p-doped or undoped electron acceptors, the carrier layers (2, 3) being arranged so as to touch one another at least in sections and at least one carrier layer (2, 3) are wetted or coated with a photovoltaic donor material (10) in a film-like manner, excitons being produced in the donor material upon irradiation of the photovoltaic device (1) with light, and the electrons being transferred directly from the photovoltaic donor material (10) into the carrier layer (2) of the p-doped or undoped electron acceptor and the holes being transferred into the carrier layer (3) of the n-doped electron donor.

2. Photovoltaic device (1) comprising a photovoltaic acceptor material (7) and a photovoltaic donor material (10),
**characterised in that**
the photovoltaic device (1) has one carrier layer (2) consisting of a number of longitudinally extending carrier elements of semiconducting materials which are in the form of fibres and consist of the acceptor material (7) consisting of a p-doped or undoped electron acceptor, and the carrier elements of the carrier layer (2) are wetted or coated in the form of a film with the photovoltaic donor material (10), onto which a further layer (6) consisting of a preferably n-doped electron donor is applied, wherein excitons are formed in the donor material when the photovoltaic device (1) is irradiated with light, and the electrons are transferred directly from the photovoltaic donor material (10) into the acceptor material (7) of the carrier layer (2) from the p-doped or undoped electron acceptor and the holes are transferred into the layer (6) from a preferably n-doped electron donor.

3. Photovoltaic device (1) according to claim 1, **characterized in that** the carrier layers (2, 3) are formed from fibres (6, 7) arranged in a layer-like manner, one carrier layer (7) having only fibres (7) as p-doped or undoped electron acceptors and the other carrier layer (6) having only fibres (6) as n-doped electron donors.

4. Photovoltaic device (1) according to claim 3, **characterized in that** the carrier layers (2, 3) of fibres (6, 7) are arranged to contact one another at least in sections, the carrier layers (2, 3) being wetted with a donor material (10) or the fibres (6, 7) of each carrier layer (2, 3) being coated with the donor material (10).

5. Photovoltaic device (1) according to claim 2, **characterized in that** the fibre-like, longitudinally extending carrier elements are arranged in a structured manner with respect to one another, preferably in the form of a mat with intersecting fibres.

6. Photovoltaic device (1) according to one of the above claims, **characterized in that** the carrier elements of the carrier layer (2) are formed from silicon carbide SiC, preferably doped with aluminium.

7. Photovoltaic device (1) according to one of the above claims, **characterized in that** the carrier layers (2, 3) consist of a thin porous structure of the n-doped electron donor and a thin porous structure of the p-doped or undoped electron acceptor.

8. Photovoltaic device (1) according to one of claims 2 to 4, **characterized in that** the fibres (6, 7) of the carrier layers (2, 3) of fibres (6, 7) can be processed textilely, in particular in the form of short fibres (6, 7) arranged in a fleece-like manner, preferably with a maximum length of 5 mm, or in the form of interwoven long fibres (6, 7), preferably with a length of more than 5 mm.

9. Photovoltaic device (1) according to one of the above claims, **characterized in that** silicon carbide SiC can be used as material for the carrier layer (2) with the p-doped or undoped electron acceptor (7).

10. Photovoltaic device (1) according to one of the above claims, **characterized in that** silicon carbide SiC can be used as material for the carrier layer (3) with the n-doped electron donor.

11. Photovoltaic device (1) according to one of claims 9 or 10, **characterized in that** the silicon carbide SiC can be used as a silicon carbide single crystal, preferably as a monocrystalline cubic 3C-SiC.

12. Photovoltaic device (1) according to one of claims 9 or 10, **characterized in that** the silicon carbide SiC can be used as a porous silicon carbide, in particular as a polycrystalline silicon carbide.

13. Method for producing fibres (6, 7) for carrier layers (2, 3) for forming a photovoltaic device (1), in particular a photovoltaic device (1) according to claim 1,
**characterised in that**
in a first step the materials to be processed form a mixture in the form of a gel in a sol-gel synthesis with one another, and in a further step the fibres (6, 7) grow in a carbothermal reduction.

14. Method according to claim 13, **characterized in that** the sol-gel synthesis is carried out using tetraethyl orthosilicate, ethanol, hydrochloric acid and saccharose.

15. Method according to one of claims 13 or 14, **characterized in that** the doping materials are introduced in the wet chemical part of the sol-gel synthesis, the doping materials being incorporated into the growing fibres (6, 7) during the thermal treatment, in particular during the thermal treatment via the gas phase.

16. Method according to any of claims 13 to 15, **characterized in that** the fibers (6, 7) are formed from silicon carbide SiC, preferably from cubic 3C-SiC, particularly preferably from monocrystalline silicon carbide SiC.

17. Method according to one of the claims 13 to 16, **characterized in that** at layer thicknesses of the acceptor material (7) of more than 100 nm additionally fullerenes, carbon nanotubes, TiO₂ nanocrystals or SiC nanocrystals are incorporated into the acceptor material.

18. Method of fabricating a layered structure for a photovoltaic device (1) as claimed in claim 1,
**characterised in that**
at least one of the two carrier layers (2, 3) is wetted or impregnated with the liquid donor material (10) and, in the still liquid state of the donor material (10), is brought into contact with the other carrier layer (3, 2) in at least sectional contact over its entire surface, the two carrier layers (2, 3) being permanently fixed to one another by curing the liquid donor material (10) in sectional contact with one another.

## Revendications

1. Dispositif photovoltaïque (1) présentant un matériau accepteur (7) photovoltaïque et un matériau donneur (10) photovoltaïque,
**caractérisé en ce que**
le dispositif photovoltaïque (1) présente au moins deux couches de support (2, 3) composées de fibres de matériaux semi-conducteurs, dont une couche de support (3) présente des donneurs d'électrons à dopage n et l'autre couche de support (2) présente un matériau accepteur faisant office d'accepteur d'électrons à dopage p ou non dopé, dans lequel les couches de support (2, 3) sont disposées l'une par rapport à l'autre en contact au moins par endroits l'une avec l'autre et au moins une couche de support (2, 3) est imprégnée ou revêtue, à la manière d'un film, d'un matériau donneur (10) photovoltaïque, dans lequel lors de l'irradiation du dispositif photovoltaïque (1) par de la lumière, des excitons se forment dans le matériau donneur et le transfert des électrons s'effectue directement du matériau donneur (10) photovoltaïque dans la couche de support (2) composée de l'accepteur d'électrons à dopage p ou non dopé et le transfert des trous s'effectue dans la couche de support (3) composée du donneur d'électrons à dopage n.

2. Dispositif photovoltaïque (1) présentant un matériau accepteur (7) photovoltaïque et un matériau donneur (10) photovoltaïque,
**caractérisé en ce que**
le dispositif photovoltaïque (1) présente une couche de support (2) composée d'un nombre d'éléments de support s'étendant en longueur à la manière de fibres composés de matériaux semi-conducteurs, constituée du matériau accepteur (7) composé d'un accepteur d'électrons à dopage p ou non dopé et les éléments de support de la couche de support (2) sont imprégnés ou revêtus, à la manière d'un film, du matériau donneur (10) photovoltaïque, sur lequel une autre couche (6) composée d'un donneur d'électrons de préférence à dopage n est appliquée, dans lequel lors de l'irradiation du dispositif photovoltaïque (1) par de la lumière, des excitons se forment dans le matériau donneur et le transfert des électrons s'effectue directement du matériau donneur (10) photovoltaïque dans le matériau accepteur (7) de la couche de support (2) composée de l'accepteur d'électrons à dopage p ou non dopé et le transfert des trous s'effectue dans la couche (6) composée d'un donneur d'électrons de préférence à dopage n.

3. Dispositif photovoltaïque (1) selon la revendication 1, **caractérisé en ce que** les couches de support (2, 3) sont formées à partir de fibres (6, 7) disposées à la manière de couches, dans lequel une couche de support (7) présente seulement des fibres (7) en tant qu'accepteurs d'électrons à dopage p ou non dopé et l'autre couche de support (6) présente seulement des fibres (6) en tant que donneurs d'électrons à dopage n.

4. Dispositif photovoltaïque (1) selon la revendication 3, **caractérisé en ce que** les couches de support (2, 3) composées de fibres (6, 7) sont disposées l'une par rapport à l'autre en contact au moins par endroits l'une avec l'autre, dans lequel les couches de support (2, 3) sont imprégnées d'un matériau donneur (10) ou les fibres (6, 7) de chaque couche de support (2, 3) sont revêtues du matériau donneur (10).

5. Dispositif photovoltaïque (1) selon la revendication 2, **caractérisé en ce que** les éléments de support s'étendant en longueur à la manière de fibres sont disposés de manière structurée les uns par rapport aux autres, de préférence sont réalisés en tant que natte avec des fibres s'entrecroisant.

6. Dispositif photovoltaïque (1) selon l'une quelconque des revendications précédentes, **caractérisé en ce que** les éléments de support de la couche de support (2) sont formés à partir de carbure de silicium SiC de préférence dopé à l'aluminium.

7. Dispositif photovoltaïque (1) selon l'une quelconque des revendications précédentes, **caractérisé en ce que** les couches de support (2, 3) sont constituées d'une structure poreuse fine du donneur d'électrons à dopage n et d'une structure poreuse fine de l'accepteur d'électrons à dopage p ou non dopé.

8. Dispositif photovoltaïque (1) selon l'une quelconque des revendications 2 à 4, **caractérisé en ce que** les fibres (6, 7) des couches de support (2, 3) composées de fibres (6, 7) peuvent subir un traitement textile, en particulier sous la forme de fibres (6, 7) courtes disposées à la manière d'un non-tissé, de préférence avec une longueur maximale de 5 mm, ou sous la forme de fibres (6, 7) longues tissées les unes avec les autres, de préférence avec une longueur de plus de 5 mm.

9. Dispositif photovoltaïque (1) selon l'une quelconque des revendications précédentes, **caractérisé en ce que** du carbure de silicium SiC peut être utilisé en tant que matériau pour la couche de support (2) avec l'accepteur d'électrons (7) à dopage p ou non dopé.

10. Dispositif photovoltaïque (1) selon l'une quelconque des revendications précédentes, **caractérisé en ce que** du carbure de silicium SiC peut être utilisé en tant que matériau pour la couche de support (3) avec le donneur d'électrons à dopage n.

11. Dispositif photovoltaïque (1) selon l'une quelconque des revendications 9 ou 10, **caractérisé en ce que** le carbure de silicium SiC peut être utilisé en tant que monocristal de carbure de silicium, de préférence en tant que 3C-SiC cubique monocristallin.

12. Dispositif photovoltaïque (1) selon l'une quelconque de revendications 9 ou 10, **caractérisé en ce que** le carbure de silicium SiC peut être utilisé en tant que carbure de silicium poreux, en particulier en tant que carbure de silicium polycristallin.

13. Procédé servant à fabriquer des fibres (6, 7) pour des couches de support (2, 3) servant à former un dispositif photovoltaïque (1), en particulier un dispositif photovoltaïque (1) selon la revendication 1,
**caractérisé en ce que**
lors d'une première étape, les matériaux à traiter forment ensemble un mélange sous la forme d'un gel lors d'une synthèse sol-gel, et lors d'une autre étape, le lavage des fibres (6, 7) se déroule dans une réduction carbothermique.

14. Procédé selon la revendication 13, **caractérisé en ce que** la synthèse sol-gel se déroule en utilisant du tétraéthylorthosilicate, de l'éthanol, de l'acide chlorhydrique et du saccharose.

15. Procédé selon l'une quelconque des revendications 13 ou 14, **caractérisé en ce que** les matériaux de dopage sont introduits dans la partie chimique par voie humide de la synthèse sol-gel, dans lequel les matériaux de dopage sont incorporés pendant le traitement thermique dans les fibres (6, 7) croissantes, en particulier pendant le traitement thermique sur la phase gazeuse.

16. Procédé selon l'une quelconque des revendications 13 à 15, **caractérisé en ce que** les fibres (6, 7) sont formées à partir de carbure de silicium SiC, de préférence à partir d'un 3C-SiC cubique, de manière particulièrement préférée à partir de carbure de silicium SiC monocristallin.

17. Procédé selon l'une quelconque des revendications 13 à 16, **caractérisé en ce qu'**en présence d'épaisseurs de couche du matériau accepteur (7) supérieures à 100 nm, des fullerènes, des nanotubes de carbone, des nanocristaux de TiO₂ ou des nanocristaux de SiC sont intercalés en outre dans le matériau accepteur.

18. Procédé servant à fabriquer une structure stratifiée pour un dispositif photovoltaïque (1) selon la revendication 1,
**caractérisé en ce que**
au moins une des deux couches de support (2, 3) est imprégnée ou imbibée du matériau donneur (10) liquide et est amenée en contact, dans l'état encore liquide du matériau donneur (10), au moins par endroits à plat avec l'autre couche de support (3, 2), dans lequel les deux couches de support (2, 3) sont fixées durablement l'une au niveau de l'autre en contact au moins par endroits l'une avec l'autre par le durcissement du matériau donneur (10) liquide.
